# EUROPEAN PATENT SPECIFICATION

(11) **EP 2 011 319 B1**
(45) Date of publication and mention of the grant of the patent: **21.11.2012**
(21) Application number: 06722306.5
(22) Date of filing: 12.04.2006
(51) Int. Cl.: H04M 1/24

(54) **GROUP WIRING SYSTEM ALLOWING LOCATING OF WIRE PAIRS AND METHOD FOR LOCATING WIRE PAIRS IN GROUP WIRING SYSTEM**
GRUPPENVERDRAHTUNGSSYSTEM ZUR ERMÖGLICHUNG DER LOKALISIERUNG VON LEITUNGSPAAREN UND VERFAHREN ZUM LOKALISIEREN VON LEITUNGSPAAREN IN EINEM GRUPPENVERDRAHTUNGSSYSTEM
SYSTÈME DE CÂBLAGE EN GROUPE PERMETTANT LA LOCALISATION DE PAIRES DE FILS ET PROCÉDÉ DE LOCALISATION DE PAIRES DE FILS DANS UN SYSTÈME DE CÂBLAGE EN GROUPE

(43) Date of publication of application: 07.01.2009
(73) Proprietor: YFC-Boneagle Electric Co., Ltd., Taoyuan, Taiwan 33061 (CN)
(72) Inventor: KU, Ying-Ming, Taoyuan 33061 (CN); LEE, Yi-Huang, Taoyuan County 33741 (CN); TSENG, Tien-Chi, Tainan County 73541 (CN)
(74) Representative: Colens, Alain M.G.M.
(86) International application number: PCT/CN2006/000654
(87) International publication number: WO 2007/115436

(56) References cited:
- WO-A1-98/12566
- CN-A- 1 450 785
- CN-A- 1 649 326
- JP-A- 11 234 710
- US-A1- 2003 073 343
- US-A1- 2004 152 351
- US-B2- 6 900 629

## Description

### Field of the Invention

The present invention relates to a group wiring system allowing locating of wire pairs. The present invention also relates to a method for locating wire pairs in a group wiring system.

### Background of the Invention

A typical communication system usually involves hundreds or even thousands of end users located at different sites or places sharing the service provided by the same server system. Some end users may connect to the server system from the internet through modems. Some end users may connect to the server system via local servers which may be far away from the server system. Some end users may connect to the server system by using hubs which may be located in the same building but different floors of the server system. Some end users may connect to the server system through a jack or socket near their working tables. Some end users may use wireless networking devices and wireless hubs to access the server system. Thousands of wires coming from different locations are gathered and connected to a distribution frame such as a patch panel stack. Management of the wires (or cables), e.g., identifying which jack on the patch panel is connected to which end user located at what remote location, is thus a critical issue in such a large server system.

Conventional methods for wire pair identification are labor-intensive and time-consuming. The network jack in the working area could not be rapidly located to the associated network receptacle, leading to troublesome locating of the wire pairs. U.S. Patent No. 6,750,643 assigned to the Assignee of the present application discloses a group wiring patching system and a method for wire pair identification. The group wiring patching system comprises a testing device and a group wiring patch device that has built-in light emitting means and filtering means coupled with wire pair receptacles. When a testing voltage is applied to the circuit of the light emitting means, the light emitting means will emit light for assisting wire pair identification. The filtering means can minimize or even eliminate loop back shorting resulted by the circuit of the connected light emitting means when communication frequency signals or low voltage signals are applied thereto. Therefore, the group wiring patching device is able to perform ordinary signal transmitting functions without the need to remove the light emitting means after the wire pair identification process is done.

However, when the wiring procedure is completed (i.e., connection to servers is completed), relocating the wire pairs of the wiring system would cause short circuit, as the voltage of the testing signals is a voltage of low direct current that will result in low impedance of the circuits for the electric components in the servers. Hence, the light emitting means built in the group wiring system could not function. As a result, relocating of the wire pairs of the wiring system requires removal of all of the server connection, which is labor-intensive and time-consuming.

US2004/0152351 discloses a group wiring device for facilitating wire pair identification between remote wire pair receptacles and said group wiring device; the group wiring device comprises a plurality of wire pair receptacles capable of receiving plugs and further comprising at least two contacts for connection with a conductive wire, a plurality of testing circuits coupled between said conductive wires of said contacts and further comprising at least one light emitting means and at least one switchmechanism connected with the light emitting means wherein the switch remains closed when no plug is mated in the receptacle and wherein the switch remains open when a plug is mated in the receptacle. A cable tester providing a DC testing voltage may be used at the remote wire pair receptacle to energize the light emitting means at the group wiring device when in closed loop.

### Summary of the Invention

An objective of the present invention is to provide a group wiring system that allows locating of wire pairs while a server system is on-line.

Another objective of the present invention is to provide a method for locating wire pairs in a group wiring system while a server system is on-line.

Detachment of the server system before the procedure for locating the wire pairs is not required. The operational efficiency is improved, and the labor and time are saved.

In accordance with a first aspect of the present invention, a group wiring system comprises a hub of a server system, a distribution frame electrically connected to the hub, the distribution frame including a plurality of wire pair receptacles, each wire pair receptacle including at least two contacts each connecting with a conductive wire, a plurality of remote receptacles electrically connected to the distribution frame and respectively in association with the wire pair receptacles of the distribution frame, a testing device electrically connected to the remote receptacles, and a plurality of testing circuits. Each testing circuit is coupled between the conductive wires of the contacts of an associated one of the wire pair receptacles. Each testing circuit comprises a light emitting means and a filtering means.

The light emitting means emit light when the testing device applies a testing voltage to the contacts. The testing voltage is a low-frequency voltage signal having a frequency higher than 200 Hz that creates a circuit impedance higher than an impedance of the filtering means when passing through the hub, thereby decaying and filtering the low-frequency voltage signal and allowing locating test while the server system is on-line.

In accordance with a second aspect of the present invention, a method is provided for locating wire pairs in a group wiring system. The group wiring system comprises a hub of a server system, a distribution frame electrically connected to the hub, the distribution frame including a plurality of wire pair receptacles, each wire pair receptacle including at least two contacts each connecting with a conductive wire, a plurality of remote receptacles electrically connected to the distribution frame and respectively in association with the wire pair receptacles of the distribution frame, a testing device electrically connected to the remote receptacles, and a plurality of testing circuits. Each testing circuit is coupled between the conductive wires of the contacts of an associated one of the wire pair receptacles. Each testing circuit comprises a light emitting means and a filtering means.

The method comprises applying a testing voltage by the testing device to the contacts to cause an associated one of the light emitting means to emit light. The testing voltage is a low-frequency voltage signal having a frequency higher than 200 Hz that creates a circuit impedance higher than an impedance of the filtering means when passing through the hub, thereby decaying and filtering the low-frequency voltage signal and allowing locating test while the server system is on-line.

Preferably, the testing device is an oscillating circuit and includes a power source. The oscillating circuit outputs the low-fi equency voltage signal.

Preferably, the frequency of the low-frequency voltage signal is in a range between 100 KHz and 3 MHz.

Other objectives, advantages, and novel features of the invention will become more apparent from the following detailed description when taken in conjunction with the accompanying drawings.

### Brief Description of the Drawings

Fig. 1 is a schematic block diagram illustrating a group wiring system in accordance with the present invention.
Fig. 2 is a schematic diagram illustrating the circuitry of the group wiring system in Fig. 1.
Fig. 3 is a schematic plan view of a distribution frame in Fig. 2.
Fig. 4 is a diagram illustrating a testing circuit of the group wiring system in Fig. 1.

### Detailed Description of the Invention

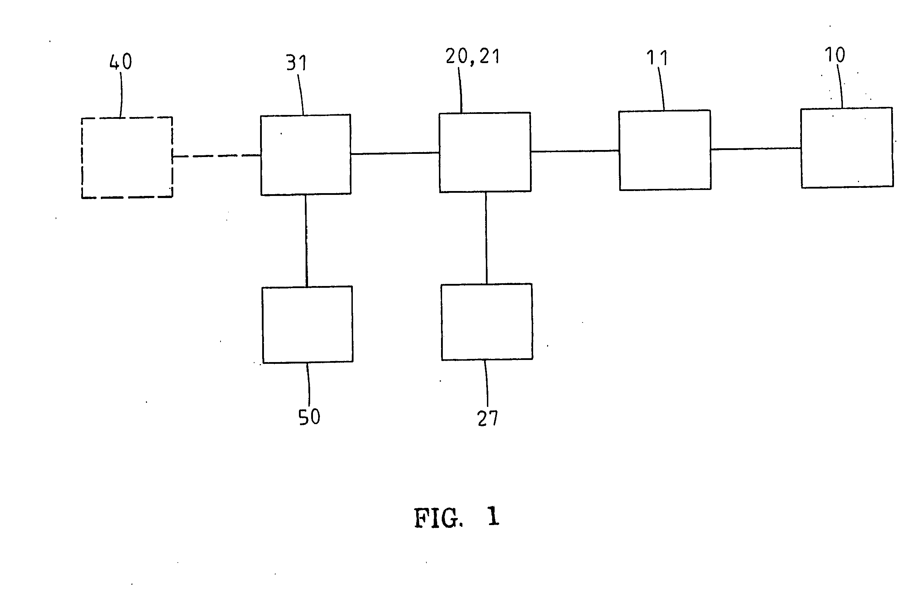

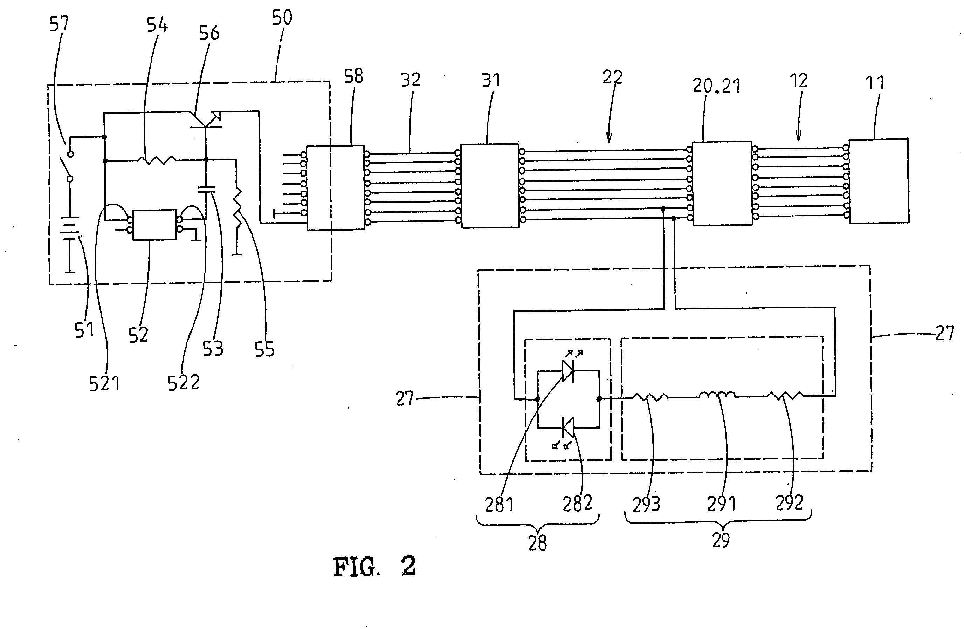

Referring to Figs. 1 and 2, a group wiring system in accordance with the present invention comprises a hub 11, a distribution frame 20 electrically connected to the hub 11, a plurality of remote receptacles 31, and a testing device 50. The hub 11 may be a hub of a server system 10. The distribution frame 20 includes a plurality of wire pair receptacles 21 respectively in association with the remote receptacles 31. The hub 11 is connected to the distribution frame 20 via jump wires 12 for networks. Each wire pair receptacle 21 is connected via a conductive wire 22 (such as a network cable) to an associated one of the remote receptacles 31. Each remote receptacle 31 is normally connected to a computer 40 in a working area via jump wires 12 for networks. Further, each remote receptacle 31 is connected to the testing device 50 during testing of wire pair locations.

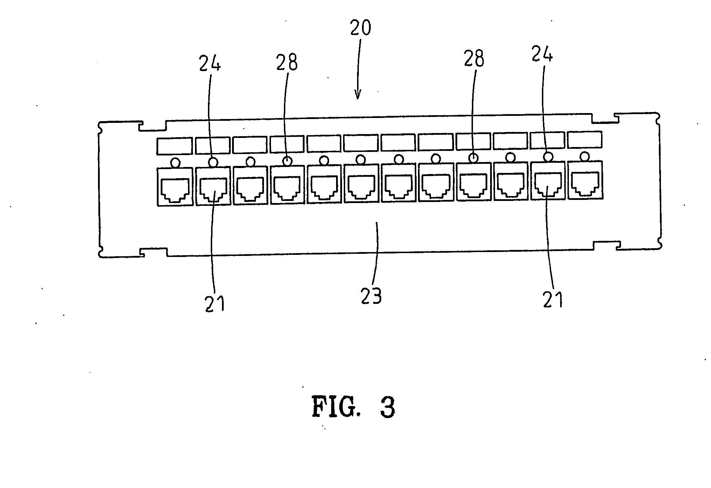

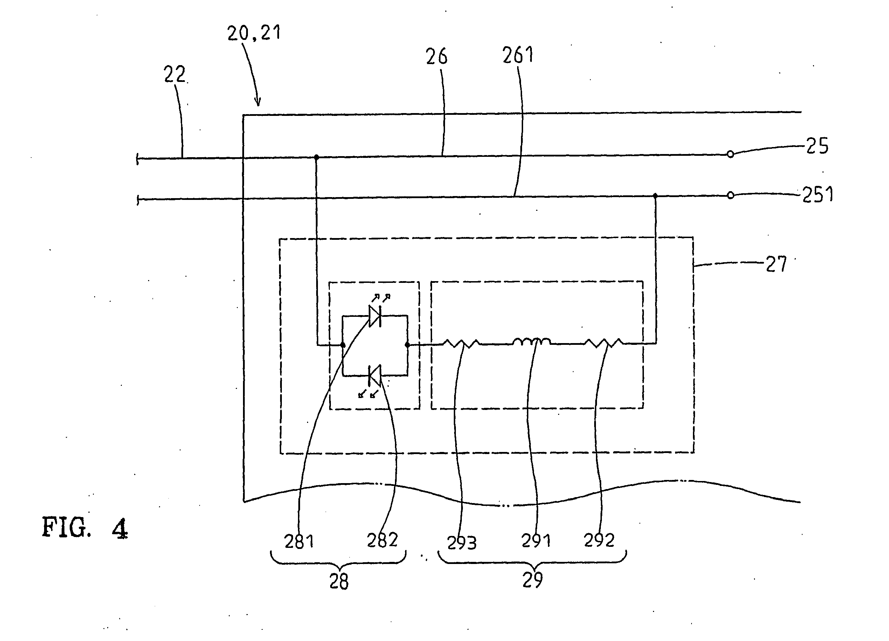

Referring to Fig. 3, the distribution frame 20 includes a panel 23 to which the wire pair receptacles 21 are mounted. Each wire pair receptacle 21 is connected to an associated one of testing circuits 27 (see Figs. 2 and 4) on a circuit board (not shown) of the distribution frame 20.

Referring to Fig. 4, each wire pair receptacle 21 includes at least two contacts 25 and 251. Each contact 25, 251 is connected to a conductive wire 26, 261. Each testing circuit 27 is coupled between two conductive wires 26 and 261 of an associated wire pair receptacle 21. Each testing circuit 27 further includes a light emitting means 28 and a filtering means 29. The light emitting means 28 emits light when a testing voltage is applied to the testing circuit 27. The filtering means 29 is connected in series between the testing circuit 27 and the light emitting means 28. The filtering means 29 can minimize or even eliminate loop back shorting caused by the testing circuit 27 when a communication frequency signal or a low-voltage signal is applied. In a preferred embodiment, the light emitting means 28 includes light-emitting diodes 281 and 282, and the filtering means 29 includes a filter 291 and two resistors 292 and 293 connected to the filter 291 in series.

Referring to Fig. 3, the panel 23 includes a plurality of light holes 24 located corresponding to the light emitting means 28 such that the light emitted from the light emitting means 28 may reach outside via the light holes 24.

Referring to Fig. 2, the testing device 50 is an oscillating circuit and includes a power source 51. The power source 51 outputs via a switch 57 such that an oscillation signal is output by Clock 522 after Vcc 521 is supplied to a quartz crystal oscillator 52. This oscillation signal passes through a capacitor 53 and added to a bias consisting of two resistors 54 and 55 and then input into a NPN transistor 56. The voltage signal is input to the base (not labeled) of the transistor 56 to control on and off of the collector (not labeled) and the emitter (not labeled) of the transistor 56. In a preferred embodiment, a signal having a frequency of 1 MHz input to the base causes on and off at the frequency of 1 MHz. The LEDs 281 and 282 of the associated wire pair receptacles 21 are turned on by providing sufficient electric current and voltage through the NPN transistor 56.

In this embodiment, the frequency of the low-frequency voltage signal must be higher than 200 Hz, preferably in a range between 100 KHz and 3 MHz. For example, if the frequency of the voltage signal is 1 MHz, the LEDs 281 and 282 are turned on and off at a frequency not perceivable to the eyes of an observer such that the LEDs 281 and 282 seem always on to the observer. The brightness of the LEDs 281 and 282 is in proportion to the frequency of the low-frequency voltage signal, and the LEDs 281 and 282 are brightest when the frequency is increased to 1 MHz. Nevertheless, further increase in frequency causes reduction in the brightness of the LEDs 281 and 282. Further, when the low-frequency voltage signal (having a frequency of, e.g., 1 MHz) is passing through a transformer (not shown) in the hub 11, the created circuit impedance is higher than the impedance of the filtering means 29 for decaying and filtering the low-frequency voltage signal, preventing short circuit of the wire pairs and assuring normal operation of the light emitting means 28. Thus, the low-frequency voltage signal can be used to proceed with wire pair identification even though the server system 10 is on-line. Namely, detachment or disconnection of the server system 1 is not required.

In a case that a low-frequency voltage signal having a frequency below 200 Hz is input to the transformer in the hub 11, the circuit impedance will be too low and thus cause short circuit, leading to abnormal operation of the light emitting means 28.

The inductance of the transformer of a 10/100/1000 Mbps Switch type hub is about 350 uH to allow significant decay of the low-frequency voltage signal having a frequency higher than 200 Hz after passing through the transformer. Nevertheless, decay of this low-frequency voltage signal is smaller after passing through the low-inductance filter 291 and resistors 292 and 293. Thus, the light emitting means 28 can be activated to emit light.

Currently available hubs include (1) IEEE802.3/IEEE802.3u10/100 Base-Tx Ethernet/Fast Ethernet, (2) IEEE802.3ab1000 Base-T Gigabit Ethernet, and (3) IEEE802.3afPOE.

In the first type of hubs, 12/36 wire pairs are used to transmit information. The signal is input to an IC in the hub after filtering as a result of passing through a transformer. Generally, the 4/5 and 7/8 wire pairs are short-circuited, connected in series with resistor(s), and grounded by capacitor(s).

In the second type of hubs, the 12/36/45/78 wire pairs are used to transmit information. The signal is input to an IC in the hub after filtering as a resulting of passing through a transformer.

In the third type of hubs, 12/36 wire pairs are used to transmit information. The signal is input to an IC in the hub after filtering as a result of passing through a transformer. Generally, the 4/5 wire pairs is short-circuited and then grounded, and the 7/8 wire pairs are short-circuited and then used to convey a power of 48 VDC.

The above-mentioned low-frequency voltage signal having a frequency higher than 200 Hz is preferably applied to a half of the wire pairs of the network cables of the above-mentioned products to avoid short circuit. In a case that products of other types are used, suitable combination of the wire pairs can be selected, allowing convenient use of this technique and allowing application on future upgraded products.

Although a specific embodiment has been illustrated and described, numerous modifications and variations are still possible without departing from the essence of the invention. The scope of the invention is limited by the accompanying claims.

## Claims

1. A group wiring system comprising:
a hub (11) of a server system (10);
a distribution frame (20) electrically connected to the hub (11), the distribution frame (20) including a plurality of wire pair receptacles (21), each said wire pair receptacle (21) including at least two contacts (25, 251) each connecting with a conductive wire (26, 261);
a plurality of remote receptacles (31) electrically connected to the distribution frame (20) and respectively in association with the wire pair receptacles (21) of the distribution frame (20);
a testing device (50) electrically connected to the remote receptacles (31);
**characterized in that**:
a plurality of testing circuits (27) each coupled between said conductive wires (26, 261) of said contacts (25, 251) of an associated one of the wire pair receptacles (21), each said testing circuit (27) comprises a light emitting means (28) and a filtering means (29);
the light emitting means (28) emits light when the testing device (50) applies a testing voltage to said contacts (25, 251), the testing voltage is a low-frequency voltage signal having a frequency higher than 200 Hz that creates a circuit impedance higher than an impedance of the filtering means (29) when passing through the hub (11), thereby decaying and filtering the low-frequency voltage signal and allowing locating test while the server system (10) is on-line

2. The group wiring system as claimed in claim 1, wherein the testing device (50) is an oscillating circuit and includes a power source (51), and the oscillating circuit outputs the low-frequency voltage signal.

3. The group wiring system as claimed in claim 1, wherein the frequency of the low-frequency voltage signal is in a range between 100 KHz and 3 MHz.

4. A method for locating wire pairs in a group wiring system, the group wiring system comprising:
a hub (11) of a server system (10),
a distribution frame (20) electrically connected to the hub (11) the distribution frame (20) including a plurality of wire pair receptacles (21), each said wire pair receptacle (21) including at least two contacts (25, 251) each connecting with a conductive wire (26, 261);
a plurality of remote receptacles (31) electrically connected to the distribution frame (20) and respectively in association with the wire pair receptacles (21) of the distribution frame (20);
a testing device (50) electrically connected to the remote receptacles (31); and
a plurality of testing circuits (27), each said testing circuit (27) being coupled between said conductive wires (26, 261) of said contacts (25, 251) of an associated one of the wire pair receptacles (21), each said testing circuit (27) comprising a light emitting means (28) and a filtering means (29);
the method comprising:
applying a testing voltage by the testing device (50) to said contacts (25, 251) to cause an associated one of the light emitting means (28) to emit light,
**characterized in that**:
the testing voltage is a low-frequency voltage signal having a frequency higher than 200 Hz that creates a circuit impedance higher than an impedance of the filtering means (29) when passing through the hub (11), thereby decaying and filtering the low-frequency voltage signal and allowing locating test while the server system (10) is on-line.

5. The method as claimed in claim 4, wherein the testing device (50) is an oscillating circuit and includes a power source (51), and the oscillating circuit outputs the low-frequency voltage signal.

6. The method as claimed in claim 4, wherein the frequency of the low-frequency voltage signal is in a range between 100 KHz and 3 MHz.

## Patentansprüche

1. Gruppenverkabelungssystem, mit
- einem Konzentrator (11) für ein Server System (10) ;
- einem Verteiler (20), der mit dem Konzentrator (11) elektrisch verbunden ist, wobei der Verteiler (20) eine Reihe von Aufnahmen für jeweils ein Leiterpaar (21) umfasst, wobei jede Aufnahme (21) eines Leiterpaars mindestens zwei Kontakte (25, 251) aufweist, die jeweils mit einem Drahtleiter (26, 261) verbunden sind ;
- einer Reihe von Aufnahmen (31), die beabstandet angeordnet sind, mit dem Verteiler (20) elektrisch verbunden sind, und den jeweiligen Aufnahmen von Leiterpaaren (21) des Verteilers (20) zugeordnet sind ;
- einer Testvorrichtung (50), die mit den beabstandet angeordneten Aufnahmen (31) elektrisch verbunden sind ; **Dadurch gekennzeichnet, dass**
- eine Reihe von Testschaltungen (27), von denen jede zwischen den besagten Leiterdrähten (26, 261) der besagten Kontakte (25, 251) der zugehörigen Aufnahme eines Leiterpaares (21) gekoppelt ist, wobei jede Testschaltung (27) mit einer Licht emittierenden Vorrichtung (28) und mit einer Filtervorrichtung (29) versehen ist ;
- die Licht emittierende Vorrichtung (28) Licht emittiert, wenn die Testvorrichtung (50) die besagten Kontakte (25, 251) unter Testspannung setzt, wobei die Testspannung ein niederfrequentes Spannungssignal ist, das eine Frequenz aufweist, die höher als 200 Hz ist, welches eine Schaltungsimpedanz erzeugt, die größer ist als die Impedanz der Filtervorrichtung (29), beim Durchgang durch den Konzentrator (11), wodurch das niederfrequentes Spannungssignal verringert und filtriert wird, und ein Lokalisierungstest ermöglicht wird, wenn das Server System (10) online ist.

2. Gruppenverkabelungssystem nach dem Anspruch 1, bei dem die Testvorrichtung (50) aus einer oszillatorischen Schaltung besteht und einer Energiequelle (51) umfasst, und bei dem die oszillierende Schaltung das niederfrequentes Spannungssignal ausgibt.

3. Gruppenverkabelungssystem nach dem Anspruch 1, bei dem die Frequenz des niederfrequenten Spannungssignals in einem Bereich von 100 kHz bis 3 MHz liegt.

4. Verfahren zur Lokalisierung von Leiterpaaren in einem Gruppenverkabelungssystem, wobei das Gruppenverkabelungssystem umfasst :
- einem Konzentrator (11) für ein Server - System (10) ;
- einem Verteiler (20), der mit dem Konzentrator (11) elektrisch verbunden ist, wobei der Verteiler (20) eine Reihe von Aufnahmen für jeweils ein Leiterpaar (21) umfasst, wobei jede Aufnahme eines Leiterpaars (21) mindestens zwei Kontakte (25, 251) aufweist, die jeweils mit einem Drahtleiter (26, 261) verbunden sind ;
- einer Reihe von Aufnahmen (31), die beabstandet angeordnet sind, mit dem Verteiler (20) elektrisch verbunden sind, und den jeweiligen Aufnahmen von Leiterpaaren (21) des Verteilers (20) zugeordnet sind ;
- einer Testvorrichtung (50), die mit den beabstandet angeordneten Aufnahmen (31) elektrisch verbunden sind ;
- eine Reihe von Testschaltungen (27), wobei jede Testschaltung (27) zwischen den besagten Leiterdrähten (26, 261) der besagten Kontakte (25, 251) der zugehörigen Aufnahme eines Leiterpaares (21) gekoppelt ist, wobei jede Testschaltung (27) mit einer Licht emittierenden Vorrichtung (28) und mit einer Filtervorrichtung (29) versehen ist ;
wobei, das Verfahren umfasst:
- die Beaufschlagung der besagten Kontakte (25, 251) mit einer Testspannung durch die Testvorrichtung (50), um die Licht Emittierung durch eine der zugehörigen Licht emittierenden Vorrichtung (28) hervorzurufen ;
**Dadurch gekennzeichnet, dass**
die Testspannung ein niederfrequentes Spannungssignal ist, das eine Frequenz aufweist, die höher als 200 Hz ist, welches eine Schaltungsimpedanz erzeugt, die größer ist als die Impedanz der Filtervorrichtung (29), beim Durchgang durch den Konzentrator (11), wodurch das niederfrequentes Spannungssignal verringert und filtriert wird, und ein Lokalisierungstest ermöglicht wird, wenn das Server Systems (10) online ist.

5. Verfahren nach dem Anspruch 4, bei dem die Testvorrichtung (50) aus einer oszillatorischen Schaltung besteht und einer Energiequelle (51) umfasst, und bei dem die oszillierende Schaltung das niederfrequentes Spannungssignal ausgibt.

6. Verfahren nach dem Anspruch 4, bei dem die Frequenz des niederfrequenten Spannungssignals in einem Bereich von 100 kHz bis 3 MHz liegt.

## Revendications

1. Système de câblage en groupe comprenant :
un concentrateur (11) d'un système serveur (10) ;
un répartiteur (20), connecté électriquement au concentrateur (11), le répartiteur (20) comprenant une série de réceptacles de paire de fils (21), chaque réceptacle de paire de fils (21) comprenant au moins deux contacts (25, 251), connecté chacun à un fil conducteur (26, 261) ;
une série de réceptacles distants (31), connectés électriquement au répartiteur (20) et respectivement, associés aux réceptacles de paire de fils (21) du répartiteur (20) ;
un dispositif de test (50) connecté électriquement aux réceptacles distants (31) ;
**caractérisé en ce que**
une série de circuits de test (27), chacun couplé entre lesdits fils conducteurs (26, 261) desdits contacts (25, 251) du réceptacle de paire de fils (21) associé, chaque circuit de test (27) comprenant un dispositif émettant de la lumière (28) et un dispositif de filtre (29) ;
le dispositif émettant de la lumière (28) émet de la lumière lorsque le dispositif de test (50) applique une tension de test sur lesdits contacts (25, 251), la tension de test est un signal de tension basse fréquence, ayant une fréquence supérieure à 200 Hz, qui crée une impédance de circuit supérieure à l'impédance du dispositif de filtre (29) lors du passage par le concentrateur (11), ce qui diminue et filtre le signal de tension basse fréquence et permet un test de localisation lorsque le système serveur (10) est en ligne.

2. Système de câblage en groupe selon la revendication 1, où le dispositif de test (50) est un circuit oscillant et comprend une source d'énergie (51), et le circuit oscillant délivre le signal de tension basse fréquence.

3. Système de câblage en groupe selon la revendication 1, où la fréquence du signal de tension basse fréquence se situe dans l'intervalle allant de 100 kHz à 3 MHz.

4. Procédé de localisation de paires de fils dans un système de câblage en groupe, le système de câblage en groupe comprenant :
un concentrateur (11) d'un système serveur (10) ;
un répartiteur (20), connecté électriquement au concentrateur (11), le répartiteur (20) comprenant une série de réceptacles de paire de fils (21), chaque réceptacle de paire de fils (21) comprenant au moins deux contacts (25, 251), connecté chacun à un fil conducteur (26, 261) ;
une série de réceptacles distants (31), connectés électriquement au répartiteur (20) et respectivement, associés aux réceptacles de paire de fils (21) du répartiteur (20) ;
un dispositif de test (50) connecté électriquement aux réceptacles distants (31) ; et
une série de circuits de test (27), chaque circuit de test (27) étant couplé entre lesdits fils conducteurs (26, 261) desdits contacts (25, 251) du réceptacle de paire de fils (21) associé, chaque circuit de test (27) comprenant un dispositif émettant de la lumière (28) et un dispositif de filtre (29) ;
le procédé comprenant :
l'application d'une tension de test par le dispositif de test (50) audits contacts (25, 251) pour provoquer l'émission de lumière par l'un des dispositif émettant de la lumière (28) associé ;
**caractérisé en ce que**
la tension de test est un signal de tension basse fréquence ayant une fréquence supérieure à 200 Hz, qui crée une impédance de circuit supérieure à l'impédance du dispositif de filtre (29) lors du passage par le concentrateur (11), ce qui diminue et filtre le signal de tension basse fréquence et permet un test de localisation lorsque le système serveur (10) est en ligne.

5. Procédé selon la revendication 4, où le dispositif de test (50) est un circuit oscillant et comprend une source d'énergie (51), et le circuit oscillant délivre le signal de tension basse fréquence.

6. Procédé selon la revendication 4, où la fréquence du signal de tension basse fréquence se situe dans l'intervalle allant de 100 kHz à 3 MHz.
